# EUROPÄISCHE PATENTSCHRIFT

(11) **EP 2 700 248 B1**
(45) Veröffentlichungstag und Bekanntmachung des Hinweises auf die Patenterteilung: **21.10.2015**
(21) Anmeldenummer: 12708095.0
(22) Anmeldetag: 20.02.2012
(51) Int. Cl.: H04R 19/00, H04R 19/04, H04R 31/00, B81B 7/00, G01H 11/06

(54) **MIKROELEKTROMECHANISCHE SCHALLDETEKTIONSVORRICHTUNG SOWIE VERFAHREN ZUR HERSTELLUNG EINER SOLCHEN**
MICROELECTROMECHANICAL SOUND DETECTION APPARATUS AND METHOD FOR PRODUCING SUCH AN APPARATUS
DISPOSITIF MICRO-ÉLECTROMÉCANIQUE DE DÉTECTION ACOUSTIQUE ET SON PROCÉDÉ DE FABRICATION

(30) Priorität: 18.04.2011 DE 102011007604
(43) Veröffentlichungstag der Anmeldung: 26.02.2014
(73) Patentinhaber: Robert Bosch GmbH, 70442 Stuttgart (DE)
(72) Erfinder: ZOELLIN, Jochen, 70195 Stuttgart (DE); SCHOLZ, Ulrike, 70825 Korntal (DE); EHRENPFORDT, Ricardo, 70825 Korntal-Muenchingen (DE)
(86) Internationale Anmeldenummer: PCT/EP2012/052831
(87) Internationale Veröffentlichungsnummer: WO 2012/143151

(56) Entgegenhaltungen:
- DE-A1-102008 039 706
- US-A1- 2005 189 635
- US-A1- 2007 252 261

## Beschreibung

Die Erfindung betrifft eine mikroelektromechanische Schalldetektionsvorrichtung, ein Verfahren zur Herstellung einer mikroelektromechanischen Schalldetektionsvorrichtung, sowie Verwendungen einer mikroelektromechanischen Schalldetektionsvorrichtung.

### Stand der Technik

Mikroelektromechanische Schalldetektionsvorrichtungen finden beispielsweise in Multimedia-Geräten, Mobiltelefonen, digitalen Fotokameras, Bluetooth-Headsets oder dergleichen Verwendung und dienen insbesondere zur Aufnahme von Sprache, beispielsweise während einer Videoaufnahme oder während eines Telefonats mit dem Mobiltelefon.

Es ist der Anmelderin bekannt geworden, dass für mikroelektromechanische Elemente zur Schalldetektion in Form von Mikrofonen zunächst das entsprechende mikroelektromechanische Element mittels Chip-On-Board (COB) -Technologie auf ein Substrat montiert, elektrisch kontaktiert und mit einem Deckel gehäust. Um Schall nun mittels des Mikrofons detektieren zu können, kann der Schall von oben durch den Deckel auf eine Membran des Mikrofons auftreffen. Eine weitere Möglichkeit besteht darin, die Mikrofonmembran mit Schall von unten, also durch das Substrat hindurch, zu beaufschlagen. Dies erfordert jedoch eine aufwendige Fertigung, um das Mikrofon nicht zu beschädigen.

Aus der US 2007/0252261 A1 ist ein Halbleiterbauelement-Package mit einem Träger und zwei Halbleiterbauelementen bekannt geworden, wobei die Halbleiterbauelemente übereinander angeordnet sind, wobei die obere Oberfläche des Trägers und ein Premold ein Aufnahmeabschnitt für das erste Halbleiterbauelement, das zweite Halbleiterbauelement und leitende Elemente bildet und wobei das Premold eine Öffnung mit einem Verschluss umfasst.

Aus der US 7166910 B2 ist ein Silizum-basiertes elektrostatisches Mikrofonpackage bekannt geworden mit einer Signalgebung, einem Substrat und einem Gehäuse. Das Silizum-basierte elektrostatische Elektromikrofonpackage umfasst dabei im Wesentlichen eine gedruckte Leiterplatte mit verschiedenen Schichten.

In der US 2005/0189635 A1 ist ein verpackter akustischer Wandler beschrieben. Der Wandler umfasst ein Gehäuse, in welchem ein Bauteil zur Schallaufnahme angeordnet ist. Beidseitig des Bauteils sind in dem Gehäuse Hohlräume vorgesehen. Das Gehäuse ist mittels Molden ausgebildet und weist eine Öffnung auf, durch welche Schall in das Gehäuse eintreten kann.

In der DE 10 2008 039 706 A1 ist ein Halbleiterbauelement mit einem Halbleiterchip beschrieben. Der Halbleiterchip, welcher auch ein Drucksensor oder ein Mikrofon sein kann, kann mit einer Formmasse bedeckt sein. Der mit der Formmasse bedeckte Halbleiterchip kann in einer weiteren Formmasse eingehaust sein.

In der US 2007/0252261 A1 ist ein Halbleiterpackage beschrieben. Das Halbleiterpackage umfasst ein Gehäuse, in welchem ein erstes Halbleiterbauteil und ein zweites Halbleiterbauteil angeordnet sind. Das erste Halbleiterbauteil ist von einem unteren Abschnitt einer Moldmasse umgeben und bedeckt eine erste Oberfläche eines Trägers. Das zweite Halbleiterbauteil, welcher auch ein Wandler oder ein Mikrofon sein kann, ist auf einer oberen Oberfläche des unteren Abschnitts der Moldmasse angeordnet.

### Offenbarung der Erfindung

Die Erfindung schafft eine mikroelektromechanische Schalldetektionsvorrichtung mit den Merkmalen des Patentanspruchs 1 sowie ein Verfahren zur Herstellung einer mikromechanischen Schalldetektionsvorrichtung mit den Merkmalen des Patentanspruchs 6.

In dem Patentanspruch 9 ist eine Verwendung einer Schalldetektionsvorrichtung gemäß zumindest einem der Ansprüche 1 bis 4 zur Druckdetektion definiert.

In dem Patentanspruch 10 ist die Verwendung einer Schalldetektionsvorrichtung gemäß zumindest einem der Ansprüche 1 bis 4 in mobilen Anwendungen definiert. In der Beschreibung der vorliegenden Anmeldung, insbesondere in den Ansprüchen, ist unter dem Begriff Hohlraum auch ein Hohlraum oder eine Aussparung mit zumindest einer Öffnung zu verstehen.

### Vorteile der Erfindung

Einer der mit der Erfindung erzielten Vorteile ist, dass dabei eine Schalldetektionsvorrichtung als kostengünstiges Mold-Package bereitgestellt werden kann, indem beispielsweise mittels des Film-Moldverfahrens das Gehäuse so geformt wird, dass damit ein Package ähnlich einem Premold bereitgestellt wird. Als Molden wird dabei das Spritzen, Gießen, Vergießen, Einhüllen, Umhüllen, insbesondere Spritzpressen einen Pressmasse, Vergussmasse und/oder einer Kunststoffmasse, insbesondere einer Epoxidmasse verstanden. Gleichzeitig kann dieses Package mit der Formgebung eines Premolds benutzt werden, um darin ein mikroelektromechanisches Element anzuordnen. Auf diese Weise ist es möglich, dass das Front- und Rückvolumen durch das Gehäuse bereitgestellt werden kann, was insgesamt das Herstellungsverfahren vereinfacht und dieses damit kostengünstiger durchgeführt werden kann. Ein weiterer Vorteil ist, dass damit auch eine Dicke des mikroelektromechanischen Elementes reduziert werden kann, da das mikroelektromechanische Element nicht mehr einen wesentlichen Anteil am Rückvolumen bereitstellen muss, was die Herstellungskosten weiter senkt. Umgekehrt ist es bei unverändertem Volumen beziehungsweise Dicke des mikroelektromechanischen Elementes möglich, das Rückvolumen kostengünstig zu vergrößern, was die Performance des mikroelektromechanischen Elementes zur Schalldetektion verbessert. Ein weiterer Vorteil ist, dass auch eine einfache Deckelung des Gehäuses ermöglicht wird mittels eines Batch-Verfahrens, was ebenfalls die Herstellungskosten deutlich reduziert. Ein weiterer Vorteil ist, dass damit die Zuverlässigkeit der mikroelektromechanischen Schalldetektionsvorrichtung und des entsprechenden Herstellungsverfahrens erhöht wird.

Die zugrundeliegende Idee der vorliegenden Erfindung besteht also darin, dass zumindest ein wesentlicher Teil des Front- und Rückvolumens bei einer Verpackung für ein mikroelektromechanisches Element zur Schallaufnahme durch das gemoldete Gehäuse beziehungsweise durch Integration in eine Moldausformung bereitgestellt wird.

Weitere Merkmale und vorteilhafte Weiterbildungen sind in den Unteransprüchen beschrieben.

Gemäß einer vorteilhaften Weiterbildung ist die zumindest eine Öffnung in einem Deckel des Gehäuses und/oder im Substrat angeordnet sind. Der erzielte Vorteil dabei ist, dass damit auf einfache und relativ zuverlässige sowie kostengünstige Weise Schall in das Gehäuse und auf das mikroelektromechanische Element zur Schalldetektion auftreffen kann, was die Detektion des Schalls erleichtert. Ist beispielsweise die zumindest eine Öffnung im Substrat angeordnet, kann dadurch das Rückvolumen noch mehr vergrößert werden, da ein gesamter Innenraum der mikroelektromechanischen Schalldetektionsvorrichtung als Rückvolumen zur Verfügung steht.

Gemäß einer weiteren vorteilhaften Weiterbildung der Erfindung ist eine anwendungsspezifische integrierte Schaltung auf dem Substrat und zumindest teilweise unterhalb des mikroelektromechanischen Elementes angeordnet und insbesondere von Moldmasse vollständig umgeben. Der erzielte Vorteil dabei ist, dass sich damit der sogenannte Footprint beziehungsweise der Platzbedarf des Gehäuses gegenüber einem Aufbau der anwendungsspezifischen integrierten Schaltung und des mikroelektromechanischen Elementes nebeneinander auf dem Substrat verringert, sodass die mikroelektromechanische Schalldetektionsvorrichtung kompakter hergestellt werden kann.

Das mikroelektromechanische Element zur Schalldetektion ist erfindungsgemäß auf einer Erhöhung innerhalb des Gehäuses angeordnet. Auf diese Weise kann das Rückvolumen erhöht werden und gleichzeitig eine Dicke des mikroelektromechanischen Elementes zur Schalldetektion insgesamt verringert werden, wodurch insgesamt eine Bauhöhe der mikroelektromechanischen Schalldetektionsvorrichtung reduziert werden kann. Aufgrund der geringeren Dicke des mikroelektromechanischen Elementes kann auch die Dauer eines Trench-Prozesses bei der Herstellung des mikroelektromechanischen Elementes reduziert werden, wodurch die Herstellungskosten des mikroelektromechanischen Elementes sinken. Befindet sich beispielsweise weiter die zumindest eine Öffnung im Substrat, so bietet die Erhöhung, auf der das mikroelektromechanische Element zur Schalldetektion angeordnet ist, einen größeren Schutz für dieses, da der Abstand zur Öffnung, die beispielsweise mittels Flusssäure geätzt wird, größer ist.

Das mikroelektromechanische Element zur Schalldetektion ist erfindungsgemäß auf einem Sockel angeordnet, der gegenüber der Erhöhung abgesenkt ist. Der erzielte Vorteil dabei ist, dass damit die mikroelektromechanische Schalldetektionsvorrichtung mit noch geringerer Bauhöhe hergestellt werden kann.

Gemäß einer weiteren vorteilhaften Weiterbildung der Erfindung weist das Substrat einen linienförmigen, insbesondere U-förmigen Bereich auf, wobei der Bereich von Moldmasse freigestellt ausgebildet ist. Der Bereich kann vorzugsweise zumindest teilweise um die Erhöhung umlaufend ausgebildet sein. Der damit erzielte Vorteil ist, dass damit ein Hohlraum im Gehäuse noch weiter vergrößert wird. Ist die zumindest eine Öffnung im Substrat angeordnet, kann somit das Rückvolumen weiter gesteigert und die Performance der mikroelektromechanischen Schalldetektionsvorrichtung weiter verbessert werden. In dem Bereich können zweckmäßigerweise Lands für eine Kontaktierung durch Drahtbonden angeordnet sein.

Gemäß einer weiteren vorteilhaften Weiterbildung des Verfahrens umfasst dieses den weiteren Schritt Anordnen einer anwendungsspezifischen integrierten Schaltung, wobei insbesondere das mikroelektromechanische Element zur Schalldetektion und die anwendungsspezifische integrierte Schaltung auf verschiedenen Ebenen oberhalb des Substrats angeordnet werden. Der erzielte Vorteil dabei ist, dass damit die mikroelektromechanische Schalldetektionsvorrichtung noch kompakter hergestellt werden kann und gleichzeitig beispielsweise eine entsprechende Auswerteschaltung in der mikroelektromechanischen Schalldetektionsvorrichtung zur Verfügung gestellt werden kann.

### Kurze Beschreibung der Zeichnungen

Weitere Merkmale und Vorteile der Erfindung ergeben sich aus der nachfolgenden Beschreibung von Ausführungsbeispielen anhand der Zeichnungen. Dabei zeigt
- Fig. 1: eine mikroelektromechanische Schalldetektionsvorrichtung gemäß einer beispielhaften ersten Ausführungsform im Querschnitt;
- Fig. 2: eine mikroelektromechanische Schalldetektionsvorrichtung gemäß Fig. 1 in der Draufsicht;
- Fig. 3: eine mikroelektromechanische Schalldetektionsvorrichtung gemäß einer beispielhaften zweiten Ausführungsform im Querschnitt;
- Fig. 4: eine mikroelektromechanische Schalldetektionsvorrichtung gemäß einer beispielhaften dritten Ausführungsform im Querschnitt;
- Fig. 5: eine mikroelektromechanische Schalldetektionsvorrichtung gemäß einer vierten Ausführungsform der vorliegenden Erfindung im Querschnitt;
- Fig. 6: eine mikroelektromechanische Schalldetektionsvorrichtung gemäß einer beispielhaften fünften Ausführungsform im Querschnitt;
- Fig. 7a,b: Draufsichten auf eine mikroelektromechanische Schalldetektionsvorrichtung gemäß einer beispielhaften sechsten und einer beispielhaften siebten Ausführungsform der vorliegenden Erfindung.

### Ausführungsformen der Erfindung

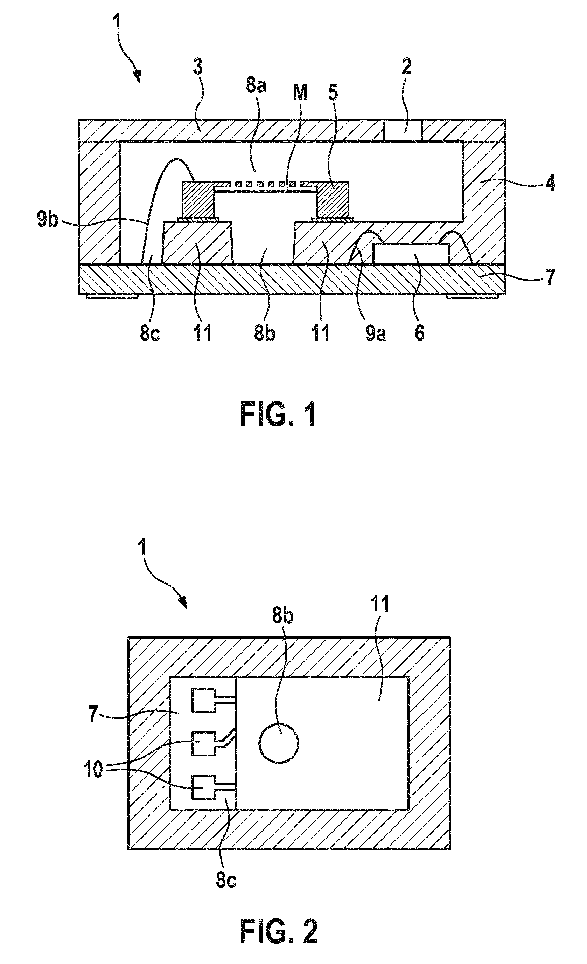

Fig. 1 zeigt in schematischer Form eine mikroelektromechanische Schalldetektionsvorrichtung gemäß einer beispielhaften ersten Ausführungsform im Querschnitt.

In Fig. 1 bezeichnet Bezugszeichen 1 eine mikroelektromechanische Schalldetektionsvorrichtung. Die mikroelektromechanische Schalldetektionsvorrichtung umfasst als Substrat Landgridarray-Leiterplatte 7. Auf der Landgridarray-Leiterplatte 7 ist eine anwendungsspezifische integrierte Schaltung 6 angeordnet, die zur elektrischen Kontaktierung über Drahtbonden 9a mit der Landgridarray-Leiterplatte 7 verbunden ist. Die anwendungsspezifische integrierte Schaltung 6 ist in einen Teil einer Wand eines Moldgehäuse 4 eingehaust. Das Moldgehäuse 4 ist ebenfalls mit der Landgridarray-Leiterplatte 7 fest verbunden. Das Moldgehäuse 4 ist im Wesentlichen innen hohl und weist einen Deckel 3 im oberen Bereich des Moldgehäuses 4 auf. Rechts einer gedachten senkrechten Mittellinie (in Fig. 1 von oben nach unten) ist im Deckel 3 eine Öffnung 2 angeordnet, durch die Schall hindurch treten kann. Weiterhin ist die anwendungsspezifische integrierte Schaltung 6 sowie deren Bonds 9a vollständig von der Wand des Moldgehäuses 4 umgeben. Die Wand des Moldgehäuses 4 erstreckt sich auch teilweise parallel zur Landgridarray-Leiterplatte 7 und bildet oberhalb der Landgridarray-Leiterplatte 7 eine Erhöhung 11, in die die anwendungsspezifische integrierte Schaltung 6 mit den Kontaktierungen 9a eingebettet ist. Die Erhöhung 11 weist dabei eine Aussparung 8b auf, welche das Rückvolumen für ein mikroelektromechanisches Element 5 zur Schalldetektion 5 bildet. Das mikroelektromechanische Element 5 zur Schalldetektion ist dabei mit seiner Membran oberhalb der Aussparung 8b angeordnet. Oberhalb und seitlich des mikroelektromechanischen Elementes 5 wird ein Frontvolumen 8a für das mikroelektromechanische Element 5 zur Schalldetektion innerhalb des Moldgehäuses 4 bereitgestellt. Das mikroelektromechanische Element 5 trennt somit Frontvolumen 8a und Rückvolumen 8b akustisch voneinander. Das mikroelektromechanische Element 5 zur Schalldetektion ist mittels Drahtbonden 9b mit der Landgridarray-Leiterplatte 7 verbunden.

Die Erhöhung 11 weist weiter eine zweite Aussparung 8c auf, sodass der Drahtbond 9b direkt auf der Landgridarray-Leiterplatte 7 das mikroelektromechanische Element 5 kontaktieren kann. Die Aussparungen 8a, 8b für das Frontvolumen und das Rückvolumen sind derart angeordnet, sodass eine Membran M des mikroelektromechanischen Elementes 5 zur Schalldetektion aus einer Ruhelage heraus reversibel auslenkbar ist und dementsprechend Schall detektieren kann.

Fig. 2 zeigt eine mikroelektromechanische Schalldetektionsvorrichtung gemäß Fig. 1 in der Draufsicht. In der Draufsicht gemäß Figur 2 ist die mikroelektromechanische Schalldetektionsvorrichtung 1 ohne Deckel 3 gezeigt. Von links nach rechts in Fig. 2 ist zunächst eine Wand des Moldgehäuses 4 zu sehen. Im Anschluss daran ist der Bereich 8c gezeigt, in dem drei Bondlands 10 zur Kontaktierung des mikroelektromechanischen Elementes 5 zur Schalldetektion angeordnet sind. Weiterhin ist die Erhöhung 11 gezeigt, die eine Aussparung 8b aufweist. Die Aussparung 8b dient als Rückvolumen für das mikroelektromechanische Element 5 zur Schalldetektion, welches in Fig. 2 nicht gezeigt ist. Die Erhöhung 11 dient bei der Herstellung des mikroelektromechanischen Schalldetektionsvorrichtung 1 als Landefläche für das mikroelektromechanische Element 5 zur Schalldetektion. Die Aussparung 8b ist gemäß Fig. 2 kreisförmig ausgebildet. Selbstverständlich sind auch andere Querschnitte denkbar, beispielsweise elliptisch oder dergleichen. Dabei kann die Aussparung auch dreidimensional ausgebildet sein, also beispielsweise kegelstumpfartig, trichterförmig oder dergleichen.

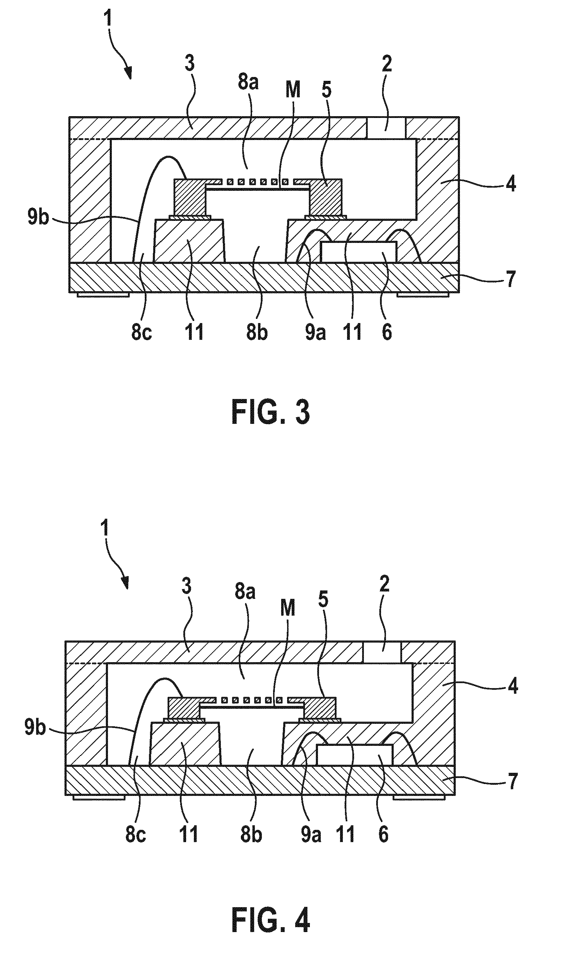

Fig. 3 zeigt eine mikroelektromechanische Schalldetektionsvorrichtung gemäß einer beispielhaften zweiten Ausführungsform der vorliegenden Erfindung im Querschnitt.

In Fig. 3 ist im Wesentlichen derselbe Aufbau der mikroelektromechanischen Schalldetektionsvorrichtung gemäß Fig. 1 gezeigt. Im Unterschied zur Fig. 1 ist die anwendungsspezifische integrierte Schaltung 6 derart angeordnet, sodass diese in der Erhöhung 11 der Wand des Moldgehäuses 4 auf der rechten Seite des Rückvolumens 8b unterhalb des mikroelektromechanischen Elementes 5 zur Schalldetektion angeordnet ist. Auf diese Weise kann die Breite der mikroelektromechanischen Schalldetektions-vorrichtung 1 verkleinert werden.

Fig. 4 zeigt eine mikroelektromechanische Schalldetektionsvorrichtung gemäß einer beispielhaften dritten Ausführungsform der vorliegenden Erfindung im Querschnitt.

In Fig. 4 ist im Wesentlichen die mikroelektromechanische Schalldetektionsvorrichtung 1 gemäß Fig. 3 gezeigt. Im Unterschied zur Fig. 3 ist das mikroelektromechanische Element 5 mit der Membran M hinsichtlich seiner Bauhöhe deutlich verringert. Dies wird ermöglicht, da ein Teil des Rückvolumens 8b mittels der Wand des Moldgehäuses 4 bereitgestellt wird. Insgesamt kann dadurch auch die Bauhöhe der mikroelektromechanischen Schalldetektionsvorrichtung 1 verringert werden.

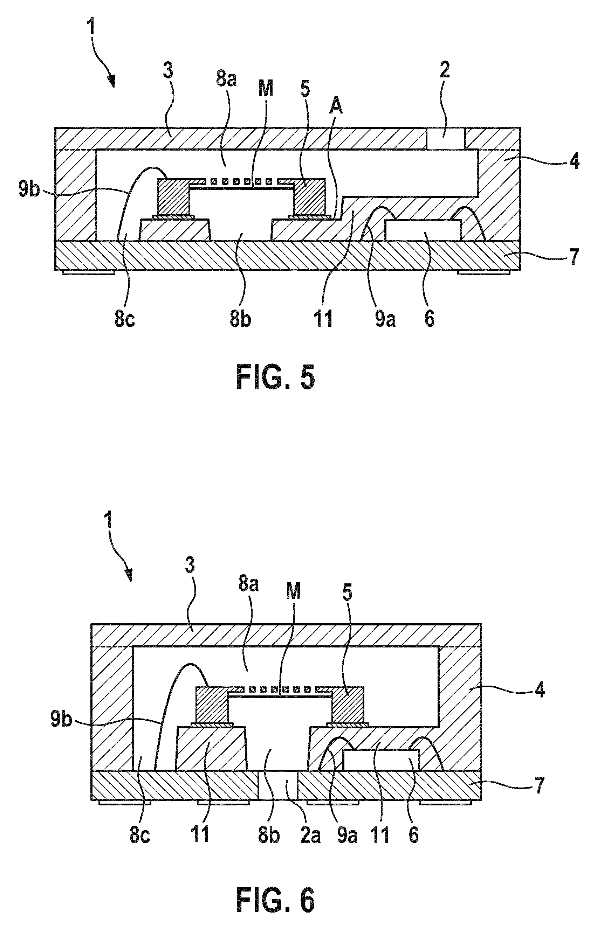

Fig. 5 zeigt eine mikroelektromechanische Schalldetektionsvorrichtung gemäß einer vierten Ausführungsform der vorliegenden Erfindung im Querschnitt.

In Fig. 5 ist im Wesentlichen die mikroelektromechanische Schalldetektionsvorrichtung 1 gemäß der Fig. 1 gezeigt. Im Unterschied zur Fig. 1 ist in der Erhöhung 11 eine Aussparung angeordnet, sodass insgesamt das mikroelektromechanische Element 5 zu Schallaufnahme gegenüber dem Bereich der Erhöhung, in der die anwendungsspezifische integrierte Schaltung 6 angeordnet ist, abgesenkt ist. Das mikroelektromechanische Element 5 zur Schalldetektion ist somit auf einem Sockel A der Erhöhung 11 angeordnet, wobei die Höhe des Sockels A relativ zur Erhöhung 11 gegenüber der Landgridarray-Leiterplatte 7 abgesenkt ist. Auf diese Weise lässt sich ebenfalls eine Verringerung der Bauhöhe der mikroelektromechanischen Schalldetektionsvorrichtung 1 erreichen.

Fig. 6 zeigt eine mikroelektromechanische Schalldetektionsvorrichtung gemäß einer beispielhaften fünften Ausführungsform der vorliegenden Erfindung im Querschnitt.

In Fig. 6 ist im Wesentlichen die mikroelektromechanische Schalldetektionsvorrichtung gemäß Fig. 3 gezeigt. Im Unterschied zur Fig. 3 weist der Deckel keine Öffnung 2 auf. Zur Beaufschlagung des mikroelektromechanischen Elementes 5 mit Schall ist anstelle der Öffnung 2 im Deckel 3 nun auf der Seite des Rückvolumens 8b in der Landgridarray-Leiterplatte 7 eine Aussparung 2a angeordnet. Auf diese Weise kann das zur Verfügung stehende Rückvolumen (hier mit Bezugszeichen 8a versehen) noch weiter vergrößert werden, da damit der gesamte Innenraum des Moldgehäuses 4 als Rückvolumen zur Verfügung steht. Das Frontvolumen (hier mit Bezugszeichen 8b bezeichnet) steht dabei im Raum zwischen der Öffnung 2a und der Membran M des mikroelektromechanischen Elementes 5 zur Schalldetektion zur Verfügung. Das mikroelektromechanische Element 5 trennt somit Frontvolumen 8b und Rückvolumen 8a akustisch voneinander.

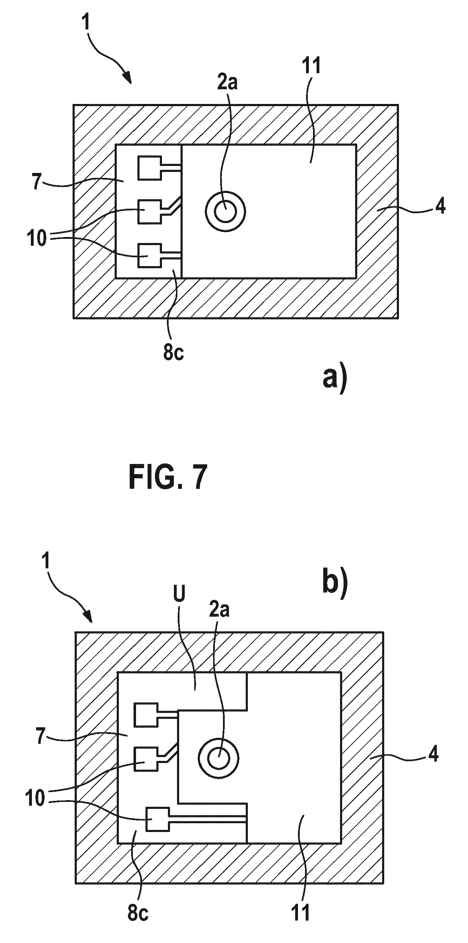

Fig. 7a, b zeigt Draufsichten auf eine mikroelektromechanische Schalldetektionsvorrichtung gemäß einer beispielhaften sechsten und einer beispielhaften siebten Ausführungsform der vorliegenden Erfindung.

In Fig. 7a ist im Wesentlichen eine Ansicht gemäß Fig. 2 von einer mikroelektromechanischen Schalldetektionsvorrichtung 1 gemäß Fig. 6 gezeigt, bei der der Schalleintritt mittels einer Öffnung 2a in der Landgridarray-Leiterplatte 7 erfolgt. Dabei ist von links nach rechts analog zu Fig. 2 eine Wand des Moldgehäuses 4, ein freigelegter Teil des Landgridarray-Leiterplatte 7 ohne Erhöhung 11 mit Drahtbondlands 10 im Bereich 8c gezeigt. Im Bereich der Erhöhung 11 ist die Öffnung 2a in der Landgridarray-Leiterplatte 7 gezeigt. Auf der rechten Seite ist wiederum eine Wand des Moldgehäuses 4 zu erkennen.

In Fig. 7b ist der Bereich 8c im Unterschied zur Fig. 7a U-förmig ausgeführt, derart, dass die Öffnung 2a innerhalb der U-Form zwischen den jeweiligen Schenkeln angeordnet ist. Auf diese Weise kann das Rückvolumen noch weiter vergrößert werden, da der zur Verfügung stehende Raum für das Rückvolumen aufgrund des größeren Bereichs ohne Erhöhung 11 innerhalb des Moldgehäuses 4 vergrößert ist.

Um eine mikroelektromechanische Schalldetektionsvorrichtung insbesondere gemäß einer der Fig. 1 bis 7 herzustellen, wird zunächst die anwendungsspezifische integrierte Schaltung 6, beispielsweise mittels Kleben oder Die-Bonden auf das Landgridarray-Substrat 7 aufgeklebt und mittels der Drahtbonden 9a elektrisch kontaktiert. Anschließend wird die anwendungsspezifische integrierte Schaltung übermoldet, wobei beispielsweise ein Moldwerkzeug mit Hilfe der Film-MoldTechnologie auf dem Landgridarray-Substrat 7 abdichtet. Während des Übermoldens werden die Öffnung zum Durchtritt von Schall und die Bondlands 10 zum Kontaktieren des noch aufzubringenden mikroelektromechanischen Elementes 5 zur Schalldetektion freigehalten und die Land-Fläche 11 des mikroelektromechanischen Elementes 5 sowie die Seitenwände des Innenraums der mikroelektromechanischen Schalldetektionsvorrichtung 1 hergestellt. Das Molden kann dabei als Batch-Verfahren im Vielfach-Nutzen erfolgen. Im Anschluss daran erfolgt das Anordnen des mikroelektromechanischen Elementes 5 zur Schalldetektion auf der gemoldeten Land-Fläche 11, beispielsweise mittels Kleben oder Die-Bonden. Im Anschluss daran erfolgt eine elektrische Kontaktierung des mikroelektromechanischen Elementes 5 zur Schalldetektion mittels Drahtbonden 9b zum Landgridarray-Substrat 7. Anschließend erfolgt die Anordnung eines Deckels 3, beispielsweise im Batchprozess, insbesondere durch Auflaminieren, Kleben, Schweißen oder dergleichen in Form beispielsweise einer Folie oder einer Platte. Zudem wird der Landgridarray-Nutzen mittels Sägen oder Laser vereinzelt.

Obwohl die vorstehende Erfindung anhand bevorzugter Ausführungsbeispiele beschrieben wurde, ist sie nicht darauf beschränkt, sondern auf vielfältige Weise modifizierbar.

Es ist beispielsweise möglich, die mikroelektromechanische Schalldetektionsvorrichtung auch als Drucksensor zu verwenden oder generell bei mikroelektromechanischen Elementen oder Aktoren mit empfindlichen, offen liegenden Strukturen.

## Patentansprüche

1. Mikroelektromechanische Schalldetektionsvorrichtung (1), umfassend
ein Substrat (7),
ein Gehäuse (4),
zumindest eine Öffnung (2, 2a) zum Durchtritt von Schall und
ein mikroelektromechanisches Element (5) zur Schallaufnahme, wobei das Gehäuse mittels Molden derart ausgebildet ist, ein Frontvolumen (8a) und ein Rückvolumen (8b) zur Schalldetektion durch das mikroelektromechanische Element (5) als Hohlräume bereitzustellen; **dadurch gekennzeichnet dass**
das mikroelektromechanische Element (5) zur Schalldetektion auf einem Sockel (A) einer Erhöhung (11) innerhalb des Gehäuses (4) angeordnet ist, und wobei der Sockel gegenüber der Erhöhung (11) abgesenkt ist.

2. Schalldetektionsvorrichtung gemäß Anspruch 1, wobei
die zumindest eine Öffnung (2, 2a) in einem Deckel (3) des Gehäuses (4) und/oder im Substrat (7) angeordnet sind.

3. Schalldetektionsvorrichtung gemäß zumindest einem der Ansprüche 1 oder 2, wobei
eine anwendungsspezifische integrierte Schaltung (6) auf dem Substrat (7) und zumindest teilweise unterhalb des mikroelektromechanischen Elementes (5) angeordnet und insbesondere vollständig von Moldmasse umgeben ist.

4. Schalldetektionsvorrichtung gemäß zumindest einem der Ansprüche 1 bis 3, wobei in die Erhöhung (11) eine anwendungsspezifische integrierte Schaltung (6) eingebettet ist.

5. Schalldetektionsvorrichtung gemäß zumindest einem der Ansprüche 1 bis 4, wobei das Substrat einen linienförmigen, insbesondere U-förmigen Bereich (8c) aufweist, wobei der Bereich (8c) von Moldmasse freigestellt ausgebildet ist.

6. Verfahren zur Herstellung einer mikromechanischen Schalldetektionsvorrichtung (1), insbesondere gemäß zumindest einem der Ansprüche 1 bis 5, umfassend die Schritte
a) Herstellen eines Substrats (7),
b) Einhausen des Substrats (7) mittels Übermolden des Substrats (7) und
c) Anordnen eines mikroelektromechanischen Elementes (5) zur Schalldetektion,
wobei das Einhausen derart erfolgt, sodass ein Frontvolumen (8a) und ein Rückvolumen (8b) für eine Schalldetektion des mikroelektromechanischen Elementes (5) als Hohlräume bereitgestellt werden; und wobei das mikroelektromechanische Element (5) zur Schalldetektion auf einem Sockel (A) einer Erhöhung (11) innerhalb des Gehäuses (4) angeordnet wird, und wobei der Sockel gegenüber der Erhöhung (11) abgesenkt ist.

7. Verfahren gemäß Anspruch 6, umfassend den weiteren Schritt: Anordnen einer anwendungsspezifischen integrierten Schaltung (6), wobei insbesondere das mikroelektromechanische Element (5) zur Schalldetektion und die anwendungsspezifische integrierte Schaltung (6) auf verschiedenen Ebenen oberhalb des Substrats (7) angeordnet werden.

8. Verfahren gemäß Anspruch 6 oder 7, umfassend den weiteren Schritt:
Einbetten einer anwendungsspezifischen integrierte Schaltung (6) in der Erhöhung (11).

9. Verwendung einer Schalldetektionsvorrichtung (1) gemäß zumindest einem der Ansprüche 1 bis 4 zur Druckdetektion.

10. Verwendung einer Schalldetektionsvorrichtung (1) gemäß zumindest einem der Ansprüche 1 bis 4 in mobilen Anwendungen.

## Claims

1. Microelectromechanical sound detection apparatus (1) comprising
a substrate (7),
a housing (4),
at least one opening (2, 2a) for passage of sound, and
a microelectromechanical element (5) for picking up sound, the housing being designed by means of moulding in such a way as to provide as cavities a front volume (8a) and a rear volume (8b) for detecting sound by means of the microelectromechanical element (5) **characterized in that**
the microelectromechanical element (5) for detecting sound is arranged on a base (A) of a prominence (11) inside the housing (4), the base being lowered relative to the prominence (11).

2. Sound detection apparatus according to Claim 1, in which the at least one opening (2, 2a) is/are arranged in a cover (3) of the housing (4) and/or in the substrate (7).

3. Sound detection apparatus according to at least one of Claims 1 and 2, in which an application-specific integrated circuit (6) is arranged on the substrate (7) and at least partially underneath the microelectromechanical element (5) and in particular is completely surrounded by moulding compound.

4. Sound detection apparatus according to at least one of Claims 1 to 3, in which an application-specific integrated circuit (6) is embedded in prominence (11).

5. Sound detection apparatus according to at least one of Claims 1 to 4, in which the substrate has a linear, in particular U-shaped region (8c), the region (8c) being designed to be clear of moulding compound.

6. Method for producing a micromechanical sound detection apparatus (1), in particular according to at least one of Claims 1 to 5, comprising the steps of
a) producing a substrate (7),
b) installing the substrate (7) by moulding over the substrate (7), and
c) disposing a microelectromechanical element (5) for detecting sound,
installing being performed so as to provide as cavities a front volume (8a) and a rear volume (8b) for the microelectromechanical element (5) to detect sound; and the microelectromechanical element (5) for detecting sound being arranged on a base (A) of a prominence (11) inside the housing (4), and the base being lowered relative to the prominence (11).

7. Method according to Claim 6, comprising the further step of:
disposing an application-specific integrated circuit (6), in particular the microelectromechanical element (5) for detecting sound and the application-specific integrated circuit (6) being disposed on different planes above the substrate (7).

8. Method according to Claim 6 or 7, comprising the further step of:
embedding an application-specific integrated circuit (6) in the prominence (11).

9. Use of a sound detection apparatus (1) according to at least one of Claims 1 to 4 for the purpose of detecting pressure.

10. Use of a sound detection apparatus (1) according to at least one of Claims 1 to 4 in mobile applications.

## Revendications

1. Ensemble microélectromécanique (1) de détection acoustique, comprenant
un substrat (7),
un boîtier (4),
au moins une ouverture (2, 2a) permettant le passage du son et
un élément microélectromécanique (5) d'enregistrement du son,
le boîtier étant formé par moulage de manière à présenter un volume avant (8a) et un volume arrière (8b) permettant en tant que cavités la détection acoustique par l'élément microélectromécanique (5), **caractérisé en ce que**
l'élément microélectromécanique (5) de détection acoustique est disposé sur un socle (A) d'un rehaussement (11) ménagé à l'intérieur du boîtier (4), le socle étant abaissé par rapport au rehaussement (11).

2. Ensemble de détection acoustique selon la revendication 1, dans lequel la ou les ouvertures (2, 2a) sont disposées dans un couvercle (3) du boîtier (4) et/ou dans le substrat (7).

3. Ensemble de détection acoustique selon au moins l'une des revendications 1 ou 2, dans lequel un circuit intégré (6) spécifique à une application est disposé sur le substrat (7) et au moins en partie en dessous de l'élément microélectromécanique (5), et est en particulier encapsulé complètement dans la pâte de moulage.

4. Ensemble de détection acoustique selon au moins l'une des revendications 1 à 3, dans lequel un circuit intégré (6) spécifique à une application est incorporé dans le rehaussement (11).

5. Ensemble de détection acoustique selon au moins l'une des revendications 1 à 4, dans lequel le substrat présente une partie (8c) de forme linéaire et en particulier en forme de U, la partie (8c) étant libre de pâte de moulage.

6. Procédé de fabrication d'un ensemble micromécanique (1) de détection acoustique, en particulier selon au moins l'une des revendications 1 à 5, le procédé comportant les étapes qui consistent à :
a) réaliser un substrat (7),
b) encapsuler le substrat (7) en recouvrant le substrat (7) de pâte de moulage et
c) placer un élément microélectromécanique (5) de détection acoustique,
l'encapsulation s'effectuant de manière à réaliser un volume avant (8a) et un volume arrière (8b) en tant que cavités pour la détection acoustique par l'élément microélectromécanique (5),
**caractérisé en ce que**
l'élément microélectromécanique (5) de détection acoustique est disposé sur un socle (A) d'un rehaussement (11) ménagé à l'intérieur du boîtier (4), le socle étant abaissé par rapport au rehaussement (11).

7. Procédé selon la revendication 6, comprenant l'étape supplémentaire qui consiste à placer un circuit intégré (6) spécifique à une application, l'élément microélectromécanique (5) de détection acoustique et le circuit intégré (6) spécifique à une application étant disposés en particulier sur des plans différents au-dessus du substrat (7).

8. Procédé selon les revendications 6 ou 7, comprenant l'étape supplémentaire qui consiste à incorporer un circuit intégré (6) spécifique à une application dans le rehaussement (11).

9. Utilisation d'un ensemble (1) de détection acoustique selon au moins l'une des revendications 1 à 4 pour la détection de pression.

10. Utilisation d'un ensemble (1) de détection acoustique selon au moins l'une des revendications 1 à 4 dans des applications mobiles.
